# EUROPEAN PATENT APPLICATION

(11) **EP 1 553 208 A2**
(43) Date of publication of application: **13.07.2005**
(21) Application number: 04028350.9
(22) Date of filing: 30.11.2004
(51) Int. Cl.: C23C 16/44, C23C 16/455

(54) **Substrate processing apparatus and cleaning method therefor**

(30) Priority: 07.01.2004 JP 2004002295
(71) Applicant: MATSUSHITA ELECTRIC INDUSTRIAL CO., LTD., Kadoma-shi, Osaka 571-8501 (JP)
(72) Inventor: Matsubara, Toshio, Imizu-gun Toyama 939-0251 (JP); Ueda, Satoshi, Takaoka-shi Toyama 933-0014 (JP); Satou, Hiroyuki, Takaoka-shi Toyama 939-1102 (JP); Uchijima, Hideto, Imizu-gun Toyama 939-0362 (JP)
(74) Representative: Grünecker, Kinkeldey, Stockmair & Schwanhäusser Anwaltssozietät

(57) **Abstract**

A substrate processing apparatus has a pressure-reducible reaction chamber, a substrate support provided in the reaction chamber, a gas inlet port provided in a wall portion of the reaction chamber to introduce a gas into the reaction chamber, a first plate provided between the substrate support and the gas inlet port in the reaction chamber and having a plurality of first holes for dispersing the gas introduced from the gas inlet port into the reaction chamber, and a second plate provided between the substrate support and the first plate in the reaction chamber in opposing relation to the first plate and having a plurality of second holes for further dispersing the gas dispersed by the first plate. The first and second plates can be moved relatively to each other such that a spacing between the first and second plates is variable.

## Description

### BACKGROUND OF THE INVENTION

The present invention relates to a substrate processing apparatus and, more particularly, to an internal structure related to cleaning in a chemical vapor deposition system for forming a thin film for a semiconductor device and to a cleaning method for the chemical vapor deposition system having the internal structure.

Recent years have been increasing tendencies in semiconductor devices toward higher integration, lower power consumption, and lower cost. For the realization of the tendencies, there have been growing demands for thinner and more uniform films as insulating films composing the semiconductor devices.

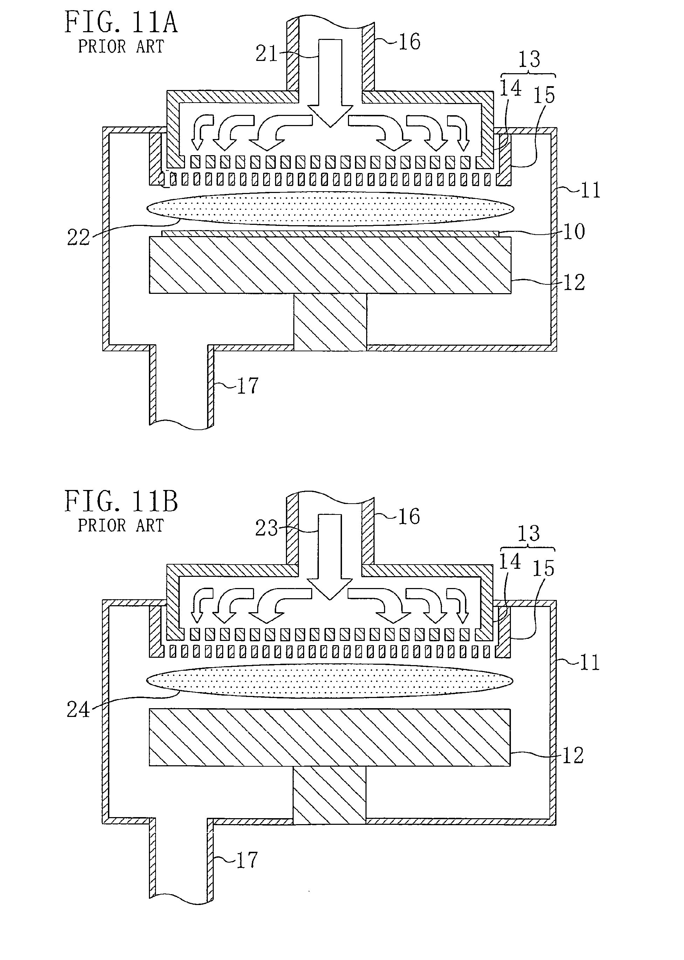

FIGS. **11A** and **11B** show schematic cross-sectional structures of a conventional single-wafer chemical vapor deposition system, of which FIG **11A** shows the internal state of the system during film deposition and FIG **11B** shows the internal state of the system during cleaning (see Japanese Laid-Open Patent Publication No. 2000-273638).

As shown in FIGS. **11A** and **11B,** a lower electrode **12** which also serves as a substrate support is provided on the bottom portion of a reaction chamber **11** such that a substrate (wafer) **10** as a processing target is placed on the lower electrode **12**. The lower electrode **12** has a heater (not shown) for adjusting the temperature of the target substrate **10**. On the other hand, an upper electrode **13** which also serves as a gas shower head for film deposition is disposed in the upper portion of the reaction chamber **11** in opposing relation to the lower electrode **12**. Specifically, the upper electrode **13** is composed of a blocker plate **14** for dispersing a gas introduced into the reaction chamber **11** and a face plate **15** for further dispersing the gas that has been dispersed by the blocker plate **14.** The blocker plate **14** and the face plate **15** can improve the thickness uniformity of a film deposited on the target substrate **10**. Each of the blocker plate **14** and the face plate **15** is provided with numerous holes for allowing the gas to pass therethrough, while an extremely narrow spacing is normally provided between the blocker plate **14** and the face plate **15**.

A gas inlet port **16** for introducing the gas into the reaction chamber **11** has been attached to the upper portion of the reaction chamber **11** via an upper electrode **13** so that the gas ejected from the gas inlet port **16** is guided toward the lower electrode **12** by passing through the blocker plate **14** and the face plate **15** in succession. An exhaust hole **17** for exhausting the gas introduced into the reaction chamber **11** to the outside thereof has been attached to the bottom portion of the reaction chamber **11**. The exhaust hole **17** is connected to an exhaust pump not shown.

A description will be given next to a film deposition step performed by using the conventional single-wafer chemical vapor deposition system with reference to FIG **11A.** First, the target substrate (wafer) **10** is placed on the lower electrode **12** to be interposed between the lower and upper electrodes **12** and **13**. Then, a material gas (reactive gas) **21** for film deposition is introduced into the reaction chamber **11** from the gas inlet port **16** through the blocker plate **14** and the face plate **15**. By applying an RF voltage between the lower and upper electrodes **12** and **13** by using an RF power source not shown, a plasma **22** composed of the reactive gas **21** is generated in a region lying between the lower and upper electrodes **12** and **13** and film deposition on the target substrate **10** is performed by exposing the target substrate **10** to the plasma **22**. Alternatively, thermal CVD is performed by heating the lower electrode **12** to about 400 °C instead of performing plasma CVD (chemical vapor deposition), thereby conducting film deposition on the target substrate **10**.

As described above, the upper electrode **13** which also serves as the gas shower head is composed of the blocker plate **14** and the face plate **15**. Accordingly, the uniformity of a film deposited on the target substrate **10** in the film deposition step shown in FIG **11A** can be improved by dispersing the reactive gas **21** introduced from the gas inlet port **16** by using the blocker plate **14** and then further dispersing the reactive gas **21** by using the face plate **15**.

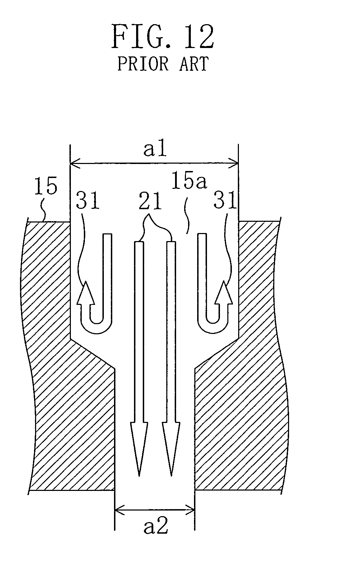

FIG **12** is an enlarged view of one of the gas holes provided in the face plate **15**. As shown in FIG **12,** each of the gas holes **15a** in the face plate **15** has the diameter (size) **a2** of an outlet set smaller than the diameter (size) **a1** of the inlet thereof for the stable flow rate of the reactive gas **21.** Under the influence of a constriction resulting from the size difference between the inlet and the outlet, a turbulent **31** occurs in the flow of the reactive gas **21** inside the gas hole **15a**.

A description will be given next to a cleaning step in the conventional single-wafer chemical vapor deposition system with reference to FIG **11B**. First, after the completion of the film deposition step shown in FIG **11A**, the target substrate **10** is retrieved from the reaction chamber **11.** Then, a cleaning gas **23** for internally cleaning the reaction chamber **11** is introduced into the reaction chamber **11** from the gas inlet port **16** through the blocker plate **14** and the face plate **15**. By applying an RF voltage between the lower and upper electrodes **12** and **13** by using an RF power source not shown, a plasma **24** composed of the cleaning gas **23** is generated in the region lying between the lower and upper electrodes **12** and **13** so that the inside of the reaction chamber **11** is exposed to the plasma **24**. This allows the removal of a reaction product that has adhered to the inside of the reaction chamber **11** during the film deposition step shown in FIG **11A**.

### SUMMARY OF THE INVENTION

However, the conventional chemical vapor deposition system described above has had the problem that an increasing amount of the reaction product adheres to the gas holes in the blocker plate **14** and the face plate **15** as the number of times of film deposition on the target substrate **10** increases, which gradually disturbs the flow of the reactive gas **21** passing through the gas holes and eventually degrades the uniformity of the deposited film.

In addition, the reactive gas (material gas) **21** introduced from the gas inlet port **16** into the reaction chamber **11** during the film deposition step is dispersed from the center portion of the blocker plate **14** to the peripheral portion thereof upon passing through the blocker plate **14**, as shown in FIG **11A**. At this time, it is ideal for the reactive gas **21** (i.e., the reactive gas **21** present in the space enclosed by the blocker plate **14**) flowing from the gas inlet port **16** toward the blocker plate **14** to have a uniform pressure such that the speed of the reactive gas **21** ejected from the gas holes in the center portion of the blocker plate **14** becomes equal to the speed of the reactive gas **21** ejected from the gas holes in the peripheral portion of the blocker plate **14.** In an actual situation, however, the speed of the reactive gas **21** ejected from the gas holes in the vicinity of the periphery of the blocker plate **14** which are located away from the gas inlet port **16** is lower than the speed of the reactive gas **21** ejected from the gas holes in the vicinity of the center of the blocker plate **14** which are closer to the gas inlet port **16**. As a result, the reactive gas **21** dwells for a longer period at the peripheral portion of the blocker plate **14** so that the reaction product tends to be more likely to adhere to the gas holes in the vicinity of the periphery of the blocker plate **14.** It is to be noted that, once the reaction product adheres to a certain point, a larger reaction product is likely to grow at the point thereafter by using the already adhered reaction product as a nuclei. Because the reaction product that has thus grown large in the gas holes in the vicinity of the periphery of the blocker plate **14** disturbs the flow of the reactive gas **21**, the amount of gas ejected from the gas holes in the vicinity of the periphery of the blocker plate 14 into the reaction chamber **11** is reduced so that another factor which causes the degradation of the thickness uniformity of the film formed on the target substrate **10** is produced disadvantageously.

There are cases, as shown in FIG **12,** where each of the gas holes **15a** in the face plate **15** is designed to have a smaller diameter from a midpoint thereof so that the flow rate of the reactive gas **21** is held constant. However, a turbulent **31** occurs in the reactive gas **21** at the point (constricted point) where the diameter of the gas hole **15a** changes so that the reaction product is likely to adhere to the gas hole **15a** due to the turbulent **31**. The reaction product renders the amount of the reactive gas **21** passing through the gas hole **15a** unstable, thereby causing another factor which degrades the thickness uniformity of the film formed on the target substrate **10**.

Even though the reaction product has adhered to the gas holes in the blocker plate **14** and the face plate **15** as described above, it is desirable that the reaction product in the gas holes are removable by plasma cleaning using a cleaning gas **23** shown in FIG **11B**. However, the plasma **24** composed of the cleaning gas **23** is generated under the face plate **15** (in the space between the face plate **15** and the target substrate **10**) so that the surface (facing the target substrate **10**) of the blocker plate **14** and the back surface (opposite to the surface of the face plate **15** facing the target substrate **10**) of the face plate **15** opposing the surface of the blocker plate **14** are less likely to be cleaned. Accordingly, it is difficult to completely remove the reaction product that has adhered to the gas holes in the blocker plate **14** and the face plate **15** by plasma cleaning shown in FIG **11B.**

In view of the foregoing, it is therefore an object of the present invention to suppress, in a chemical vapor deposition system comprising an electrode composed of a blocker plate and a face plate in a reaction chamber, the adhesion of a reaction product to gas holes in each of the plates or remove the reaction product that has adhered to the gas holes and thereby improve the thickness uniformity of a film formed on a target substrate or prevent the degradation of the film thickness uniformity.

Structures of the substrate processing apparatus according to the present invention for attaining the foregoing object will be listed herein below.
(1) A substrate processing apparatus comprising: a pressure-reducible reaction chamber; a substrate support provided in the reaction chamber; a gas inlet port provided in a wall portion of the reaction chamber to introduce a gas into the reaction chamber; a first plate provided between the substrate support and the gas inlet port in the reaction chamber and having a plurality of first holes for dispersing the gas introduced from the gas inlet port into the reaction chamber; and a second plate provided between the substrate support and the first plate in the reaction chamber in opposing relation to the first plate and having a plurality of second holes for further dispersing the gas dispersed by the first plate, wherein the first and second plates can be moved relatively to each other such that a spacing between the first and second plates is variable.
(2) In the substrate processing apparatus listed in the foregoing (1), a first RF voltage can be applied between the first and second plates and a second RF voltage can be applied between the second plate and the substrate support.
(3) A substrate processing apparatus comprising: a pressure-reducible reaction chamber; a substrate support provided in the reaction chamber; a gas inlet port provided in a wall portion of the reaction chamber to introduce a gas into the reaction chamber; a plate provided between the substrate support and the gas inlet port in the reaction chamber and having a plurality of holes for dispersing the gas introduced from the gas inlet port into the reaction chamber; and a heater provided on the plate to heat the plate.
(4) A substrate processing apparatus comprising: a pressure-reducible reaction chamber; a substrate support provided in the reaction chamber; a gas inlet port provided in a wall portion of the reaction chamber to introduce a gas into the reaction chamber; a plate provided between the substrate support and the gas inlet port in the reaction chamber and having a plurality of holes for dispersing the gas introduced from the gas inlet port into the reaction chamber; and a vibration source provided on the plate to apply an ultrasonic vibration to the plate.
(5) In the substrate processing apparatus listed in the foregoing (3) or (4), the plate is composed of: a first plate having a plurality of first holes for dispersing the gas introduced from the gas inlet port into the reaction chamber; and a second plate provided between the substrate support and the first plate in opposing relation to the first plate and having a plurality of second holes for further dispersing the gas that has been dispersed by the first plate.
(6) A substrate processing apparatus comprising: a pressure-reducible reaction chamber; a substrate support provided in the reaction chamber; a gas inlet port provided in a wall portion of the reaction chamber to introduce a gas into the reaction chamber; a plate provided between the substrate support and the gas inlet port in the reaction chamber and having a plurality of holes for dispersing the gas introduced from the gas inlet port into the reaction chamber; and a plurality of pins provided in the reaction chamber to oppose the plurality of holes in the plate in a one-to-one correspondence, wherein the plurality of pins are movable to be fitted into the plurality of holes in a one-to-one correspondence.
(7) In the substrate processing apparatus listed in the foregoing (6), the plate is composed of: a first plate having a plurality of first holes for dispersing the gas introduced from the gas inlet port into the reaction chamber; and a second plate provided between the substrate support and the first plate in opposing relation to the first plate and having a plurality of second holes for further dispersing the gas that has been dispersed by the first plate and the plurality of the pins are provided movable between the gas inlet port and the first plate in opposing relation to the plurality of first holes in such a manner as to be fitted into the plurality of first holes in a one-to-one correspondence.
(8) In the substrate processing apparatus listed in the foregoing (6), the plate is composed of: a first plate having a plurality of first holes for dispersing the gas introduced from the gas inlet port into the reaction chamber; and a second plate provided between the substrate support and the first plate in opposing relation to the first plate and having a plurality of second holes for further dispersing the gas that has been dispersed by the first plate and the plurality of pins are containable in the substrate support and protruding movably from the substrate support to be fitted into the plurality of second holes in a one-to-one correspondence.
(9) A substrate processing apparatus comprising: a pressure-reducible reaction chamber; a substrate support provided in the reaction chamber; a gas inlet port provided in a wall portion of the reaction chamber to introduce a gas into the reaction chamber; and a plate provided between the substrate support and the gas inlet port in the reaction chamber and having a plurality of holes for dispersing the gas introduced from the gas inlet port into the reaction chamber, wherein that one of the plurality of holes which is located in a peripheral portion of the plate has a size larger than a size of that one of the plurality of holes located in a center portion of the plate.
(10) A substrate processing apparatus comprising: a pressure-reducible reaction chamber; a substrate support provided in the reaction chamber; a gas inlet port provided in a wall portion of the reaction chamber to introduce a gas into the reaction chamber; and a plate provided between the substrate support and the gas inlet port in the reaction chamber and having a plurality of holes for dispersing the gas introduced from the gas inlet port into the reaction chamber, wherein each of the plurality of holes is larger in size at a portion thereof closer to an inlet for the gas than at a portion thereof closer to an outlet for the gas and a tilt angle of at least one portion of an inner wall surface of each of the plurality of holes relative to a flowing direction of the gas is not more than 45°.

Structures of a cleaning method for the substrate processing apparatus according to the present invention will be listed herein below.

A cleaning method for the substrate processing apparatus listed in the foregoing (2), the method comprising the steps of: moving the first and second plates relatively to each other to set a spacing between the first and second plates to a value which allows generation of a plasma using the first RF voltage; supplying a cleaning gas into the reaction chamber from the gas inlet port through the plurality of first holes in the first plate and the plurality of second holes in the second plate; and applying at least one of the first and second RF voltages to generate a plasma composed of the cleaning gas in at least one of a space between the first and second plates and a space between the second plate and the substrate support and thereby remove a reaction product that has resulted from a process using the substrate processing apparatus and adhered to the first and second plates.

A cleaning method for the substrate processing apparatus listed in the foregoing (3), the method comprising the steps of: supplying a cleaning gas into the reaction chamber from the gas inlet port through the plurality of holes in the plate; and heating the plate to a temperature not less than 150 °C by using the heater and thereby removing a reaction product that has resulted from a process using the substrate processing apparatus and adhered to the plate.

A cleaning method for the substrate processing apparatus listed in the foregoing (4), the method comprising the steps of: supplying a cleaning gas into the reaction chamber from the gas inlet port through the plurality of holes in the plate; and applying an ultrasonic vibration to the plate by using the vibration source and thereby removing a reaction product that has resulted from a process using the substrate processing apparatus and adhered to the plate.

Thus, the present invention can suppress the adhesion of the reaction product to the gas holes in the plates of the gas shower head or the like in the substrate processing apparatus such as a chemical vapor deposition system or the like or allow easy removal of the reaction product that has adhered to the gas holes. This prevents, when a thin film or the like is formed on the substrate, the increasing degradation of the film thickness uniformity caused by repeated film deposition.

That is, the present invention relates to an internal structure related to cleaning in the substrate processing apparatus and to a cleaning method for the apparatus having the structure and is particularly useful when applied to a chemical vapor deposition system for forming thin films for semiconductor devices or the like.

### BRIEF DESCRIPTION OF THE DRAWINGS

FIG **1** is a view showing a schematic cross-sectional structure of a substrate processing apparatus according to a first embodiment of the present invention (during film deposition);
FIG **2** is a view showing a schematic cross-sectional structure of the substrate processing apparatus according to the first embodiment (during cleaning);
FIG **3** is a view showing a schematic cross-sectional structure of a substrate processing apparatus according to a second embodiment of the present invention;
FIG **4** is a view showing a schematic cross-sectional structure of a substrate processing apparatus according to a third embodiment of the present invention;
FIG **5** is a view showing a schematic cross-sectional structure of a substrate processing apparatus according to a fourth embodiment of the present invention (during film deposition);
FIG **6** is a view showing a schematic cross-sectional structure of the substrate processing apparatus according to the fourth embodiment (during cleaning);
FIG **7** is a view showing a schematic cross-sectional structure of a substrate processing apparatus according to a fifth embodiment of the present invention (during film deposition);
FIG. **8** is a view showing a schematic cross-sectional structure of the substrate processing apparatus according to the fifth embodiment (during cleaning);
FIG. **9** is a view showing a schematic cross-sectional structure of a substrate processing apparatus according to a sixth embodiment of the present invention;
FIG. **10A** is a view showing a cross-sectional structure of one of gas holes in the face plate of a substrate processing apparatus according to a seventh embodiment of the present invention and FIGS. **10B** and **10C** are views each showing a cross-sectional structure of one of gas holes in the face plate of a conventional substrate processing apparatus;
FIG. **11A** is a view showing a schematic cross-sectional structure of the conventional substrate processing apparatus (during film deposition) and FIG **11B** is a view showing a schematic cross-sectional structure of the conventional substrate processing apparatus (during cleaning); and
FIG **12** is an enlarged view of one of the gas holes in the face plate of the conventional substrate processing apparatus.

### DETAILED DESCRIPTION OF THE INVENTION

### EMBODIMENT 1

Referring to the drawings, a substrate processing apparatus according to a first embodiment of the present invention and a cleaning method therefor will be described herein below.

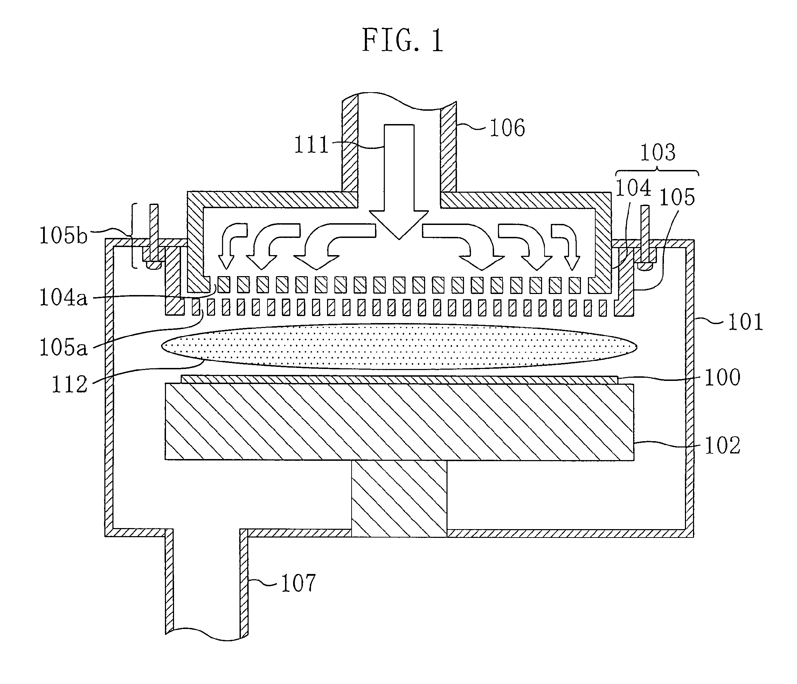

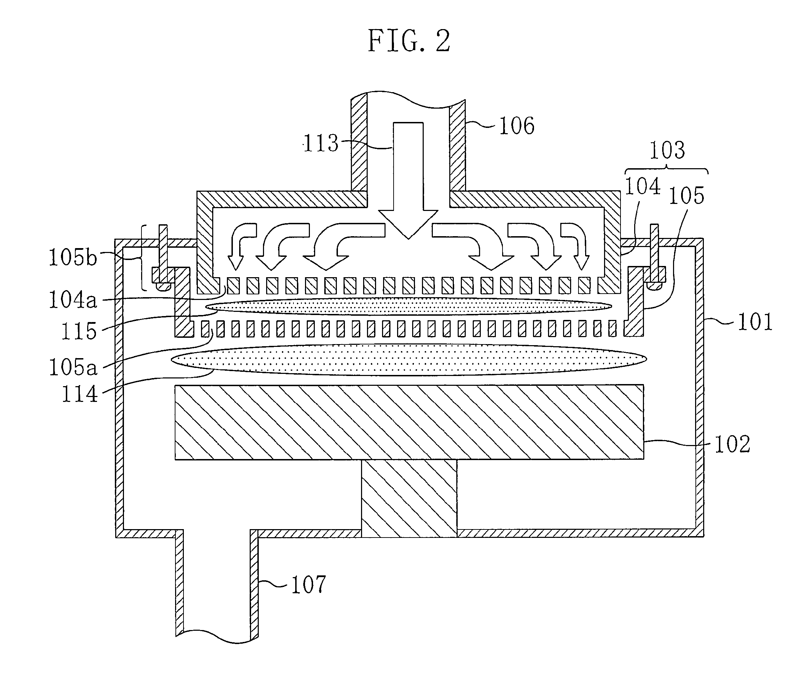

FIGS. **1** and **2** show schematic cross-sectional structures of the substrate processing apparatus according to the first embodiment (which is specifically a chemical vapor deposition system), of which FIG **1** shows the internal state of the apparatus during film deposition and FIG **2** shows the internal state of the apparatus during cleaning.

As shown in FIGS. **1** and **2**, a lower electrode **102** which also serves as a substrate support is disposed on the bottom portion of a reaction chamber **101** such that a substrate (wafer) **100** as a processing target is placed on the lower electrode **102**. The reaction chamber **101** is a pressure-reducible reaction chamber in which a pressure condition lower than a normal pressure (an atmospheric pressure) can be realized. The lower electrode **102** has a heater (not shown) for adjusting the temperature of the target substrate **100**.

On the other hand, an upper electrode **103** which also serves as a gas shower head for film deposition is disposed in the upper portion of the reaction chamber **101** in opposing relation to the lower electrode **102**. The upper electrode **103** is composed of a blocker plate **104** for dispersing a gas introduced into the reaction chamber **101** and a face plate **105** for further dispersing the gas that has been dispersed by the blocker plate **104.** The blocker plate **104** and the face plate **105** can improve the thickness uniformity of a film deposited on the target substrate **100**.

Specifically, the blocker plate **104** is composed of: a first gas dispersing portion provided with a plurality of gas holes **104a** for allowing the gas to pass therethrough; a ceiling portion disposed over the first gas dispersing portion in opposing relation thereto and having a gas inlet port **106** for introducing the gas into the reaction chamber **101** attached thereto; and side portions for defining the space between the ceiling portion and the first gas dispersing portion. The first gas dispersing portion of the blocker plate **104** is disposed in parallel relation to the substrate support surface of the lower electrode **102**. The ceiling portion of the blocker plate **104** composes a part of the ceiling portion of the reaction chamber **101** and is disposed in parallel relation to the first gas dispersing portion of the blocker plate **104**. The gas inlet port **106** has been attached to the center of the ceiling portion of the blocker plate **104**. In other words, the gas inlet port **106** is opposed to the center of the first gas dispersing portion of the blocker plate **104**, i.e., the center of the substrate support surface of the lower electrode **102**. Consequently, the gas introduced from the gas inlet port **106** into the space enclosed by the blocker plate **104** is dispersed from the center portion of the first gas dispersing portion of the blocker plate **104** to the peripheral portion thereof upon passing through the first gas dispersing portion of the blocker plate **104.**

The face plate **105** is composed of: a second gas dispersing portion provided with a plurality of gas holes **105a** disposed under the first gas dispersing portion of the blocker plate **104** in opposing relation thereto to allow the gas to pass therethrough; and side portions for defining the space between the blocker plate **104** and the face plate **105**. In other words, the second gas dispersing portion of the face plate **105** is disposed in the space between the first gas dispersing portion of the blocker plate **104** and the substrate support surface of the lower electrode **102** in parallel relation to the substrate support surface of the lower electrode **102**. The present embodiment is characterized in that the side portions of the face plate **105** have been attached to the ceiling portion of the reaction chamber **101** via a mechanism **105b** for moving the face plate **105** in upward and downward directions (vertical directions). This enables the face plate **105** to be moved downwardly from the position in extremely proximity to the blocker plate **104** (it will easily be appreciated that the face plate **105** can also be moved in the opposite direction). Thus, the spacing between the blocker plate **104** (the first gas dispersing portion) and the face plate **105** (the second gas dispersing portion) has been set variable in the present embodiment.

An exhaust hole **107** for exhausting the gas introduced into the reaction chamber **101** to the outside thereof has been attached to the bottom portion of the reaction chamber **101**. The exhaust **107** is connected to an exhaust pump not shown.

In the substrate processing apparatus shown in FIGS. **1** and **2**, RF voltages can be applied between the lower and upper electrodes **102** and **103** by using an RF power source not shown. Specifically, the present embodiment is characterized in that a first RF voltage can be applied between the blocker plate **104** (the first gas dispersing portion) and the face plate **105** (the second gas dispersing portion) and a second RF voltage can be applied between the face plate **105** (the second gas dispersing portion) and the lower electrode **102**. The RF power source may be connected either to the upper electrode **103** or to the lower electrode **102.**

Referring to FIG **1**, a description will be given next to an example of a film deposition step performed by using the chemical vapor deposition system according to the present embodiment. First, the face plate **105** (the second gas dispersing portion) is moved to a position extremely close to the blocker plate **104** (the first gas dispersing portion) by using the mechanism **105b**. Then the target substrate (wafer) **100** is placed on the lower electrode **102** and a material gas (reactive gas) **111** for film deposition is introduced into the reaction chamber **101** from the gas inlet port **106** through the blocker plate **104** and the face plate **105**, while the target substrate 100 is heated to about 400 °C. By applying an RF voltage between the lower and upper electrodes **102** and **103** by using the RF power source not shown, a plasma **112** composed of the reactive gas **111** is generated in the region lying between the lower and upper electrodes **102** and **103** so that film deposition on the target substrate **100** is performed by exposing the target substrate 100 to the plasma **112**. Alternatively, thermal CVD is performed by heating the lower electrode **102** to about 400 °C using a heater (not shown) instead of performing plasma CVD, thereby conducting film deposition on the target substrate **100**. Specifically, a TEOS (tetraethylorthosilicate) gas, an ozone gas, a TEPO (triethyl phosphate) gas, and a TEB (triethoxyboron) gas, e.g., are allowed to flow as the reactive gas **111** (process gas) in the reaction chamber **101** to deposit a BPSG (boron-doped phospho-silicate glass) film through the thermal reaction of the foregoing process gas over the target substrate **100**.

In the film deposition step shown in FIG. **1**, the spacing between the blocker plate **104** (the first gas dispersing portion) and the face plate **105** (the second gas dispersing portion) is set to a value (e.g., about 1 mm) which renders the distribution (horizontal distribution) of the reactive gas **111** uniform over the surface of the target substrate **100**.

In the film deposition step shown in FIG **1**, the upper electrode **103** which also serves as the gas shower head is composed of the blocker plate **104** and the face plate **105** so that the uniformity of the film deposited on the target substrate **100** can further be improved by dispersing the reactive gas **111** introduced from the gas inlet port **106** by using the blocker plate **104** and further dispersing the reactive gas by using the face plate **105.**

Referring to FIG **2,** a description will be given next to an example of a cleaning step performed by using the chemical vapor deposition system according to the present embodiment. First, the target substrate **100** is retrieved from the reaction chamber **101** after the completion of the film deposition step shown in FIG **2.** Then, a cleaning gas **113** such as a C₂F₆ gas or an NF₃ gas for internally cleaning the reaction chamber **101** is introduced into the reaction chamber **101** from the gas inlet port **106** through the blocker plate **104** and the face plate **105**. At this time, the distance between the face plate **105** (the second gas dispersing portion) and the blocker plate **104** (the first gas dispersing portion) is set to a value (e.g., about 3 to 20 mm) which allows sufficient generation of a plasma using an RF voltage (the first RF voltage) applied between the two plates by lowering the face plate **105** in level by using the mechanism **105b**. Then, the RF voltage (the second RF voltage) and the first RF voltage are applied individually between the face plate **105** and the lower electrode **102** and between the face plate **105** and the blocker plate **104** by using the RF power source not shown, thereby generating a plasma **114** composed of the cleaning gas **113** in the region lying between the face plate **105** (the second gas dispersing portion) and the lower electrode **102**, while generating a plasma **115** composed of the cleaning gas **113** in a region lying between the face plate **105** (the second gas dispersing portion) and the blocker plate **104** (the first gas dispersing portion). The plasmas **114** and **115** allows the decomposition and removal of a reaction product (composed mainly of a silicon oxide) that has adhered to the inner walls of the reaction chamber **101**, to the blocker plate **104** including the gas holes **104a** thereof, to the face plate **105** and the gas holes **105a** thereof, and the like.

In particular, the present embodiment also allows the removal of a reaction product that has adhered to the gas holes **104a** in the blocker plate **104**, which has been difficult to be removed by using a prior art technology, by using the plasma **115** generated between the face plate **105** and the blocker plate **104**.

Although the first embodiment has used the lower electrode **102** as the substrate support, a substrate support on which the target substrate **100** is placed may also be provided between the lower electrode **102** and the upper electrode **103** in addition to the lower electrode **102**.

The first embodiment has provided the mechanism **105b** for moving the face plate **105** in upward and downward directions (vertical directions) to provide a variable spacing between the blocker plate **104** (the first gas dispersing portion) and the face plate **105** (the second gas dispersing portion). However, the present invention is not limited thereto. It is also possible to provide a mechanism for moving the blocker plate **104** in upward and downward directions (vertical directions) in addition to the mechanism **105b** or without providing the mechanism **105b**.

In the first embodiment, the configuration and location of the blocker plate **104** are not particularly limited provided that the gas introduced from the gas inlet port **106** into the reaction chamber **101** can be dispersed between the substrate support (the lower electrode **102**) and the gas inlet port **106**. For example, the blocker plate **104** may also be composed of the same gas dispersing portion (the first gas dispersing portion) as used in the present embodiment and side portions attached to the ceiling portion of the reaction chamber **101** in such a manner as to define the space between the gas dispersing portion and the ceiling portion.

In the first embodiment, the configuration and location of the face plate **105** are not particularly limited, either, provided that the gas dispersed by the blocker plate **104** can further be dispersed in the space between the substrate support (the lower electrode **102**) and the blocker plate **104**. For example, the face plate **105** may also be composed of a gas dispersing portion (the second gas dispersing portion) having both ends attached to the sidewall portions of the reaction chamber **101**.

In the cleaning step shown in FIG **2**, the first embodiment has simultaneously performed the application of the second RF voltage between the face plate **105** and the lower electrode **102** and the application of the first RF voltage between the face plate **105** and the blocker plate **104** to simultaneously generate the plasma **114** in the region lying between the face plate **105** and the lower electrode **102** and the plasma **115** in the region lying between the face plate **105** and the blocker plate **104**. However, it is also possible to individually set a period during which the application of the first RF voltage is performed and a period during which the application of the second RF voltage is performed and thereby individually set a period during which cleaning is performed by using the plasma **114** and a period during which cleaning is performed by using the plasma **115**.

Although the first embodiment has described primarily the case where the chemical vapor deposition system is used, the same effects are achievable even when another substrate processing apparatus, e.g., a plasma etching apparatus (particularly the electrode structure and the cleaning of the apparatus) using a depositive gas is used instead.

### EMBODIMENT 2

Referring to the drawings, a substrate processing apparatus according to a second embodiment of the present invention and a cleaning method therefor will be described herein below.

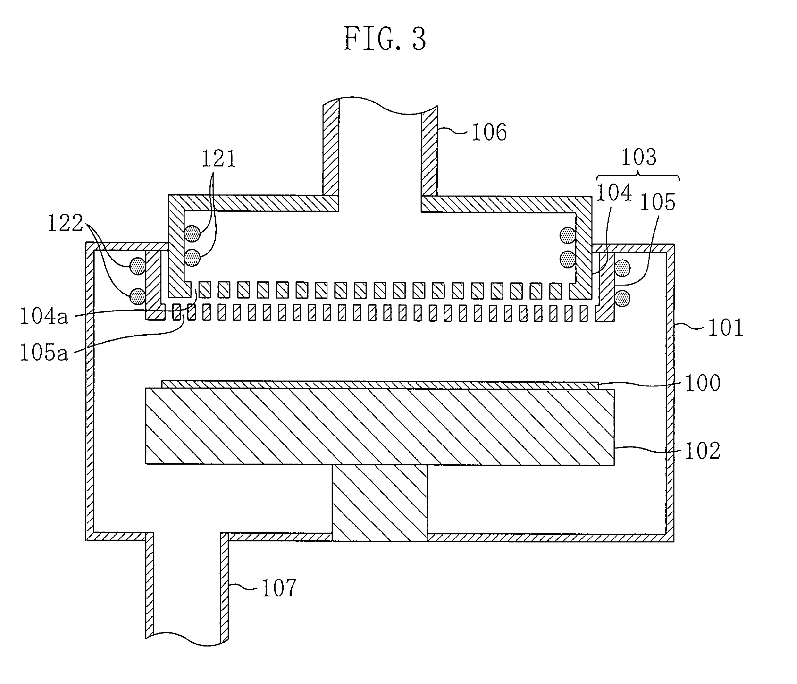

FIG **3** shows a schematic cross-sectional structure of the substrate processing apparatus (specifically a chemical vapor deposition system) according to the second embodiment. The description of the members shown in FIG **3** which are the same as those shown in FIGS. **1** and **2** will be omitted by retaining the same reference numerals as used in the first embodiment.

As shown in FIG **3**, the upper electrode **103** for generating a plasma is composed of the blocker plate **104** and the face plate **105** in the substrate processing apparatus according to the present embodiment in the same manner as in the first embodiment. However, the present embodiment is characterized in that first heaters **121** are attached to the inner wall surfaces of the side portions of the blocker plate **104** and second heaters **122** are attached to the outer wall surfaces of the side portions of the face plate **105**. Although the side portions of the face plate **105** have been attached to the ceiling portion of the reaction chamber **101** without intervention of the mechanism **105b** according to the first embodiment, it will easily be appreciated that the mechanism **105b** may also be provided.

In the film deposition step in the chemical vapor deposition system according to the present embodiment, the target substrate (wafer) **100** is placed on the lower electrode **102** and then a process gas is introduced into the reaction chamber **101** from the gas inlet port **106** through the gas holes in each of the blocker plate **104** and the face plate **105**, in the same manner as in the first embodiment. At this stage, a plasma composed of the process gas is generated in the region lying between the lower and upper electrodes **102** and **103** by applying an RF voltage between the lower and upper electrodes **102** and **103** and film deposition on the target substrate **100** is performed by exposing the target substrate **100** to the plasma. Alternatively, thermal CVD is performed instead of performing plasma CVD by heating the lower electrode **102** to about 400 °C using the heaters (not shown) so that film deposition on the target substrate **100** is performed.

In the cleaning step using the chemical vapor deposition system according to the present embodiment, the target substrate **100** is retrieved from the reaction chamber **101** after the completion of the film deposition step described above and then the blocker plate **104** and the face plate **105** are heated by using the first heaters **121** provided on the inner walls of the blocker plate **104** and the second heaters **122** provided on the outer walls of the face plate **105**, while the pressure inside the reaction chamber **101** is held in a properly reduced state. Although each of the plates is heated to about 100 °C in conventional plasma cleaning which does not perform heating using a heater, the present embodiment heats the blocker plate **104** and the face plate **105** to a temperature not less than 150 °C, preferably not less than 200 °C. Consequently, each of the gas holes **104a** in the blocker plate **104** and the gas holes **105a** in the face plate **105**, which are extremely small holes (fine holes), is heated to the same temperature as each of the plates. This allows the reaction product that has adhered to the gas holes **104a** in the blocker plate **104** and the gas holes **105a** in the face plate **105** to be efficiently vaporized or evaporated in a high-temperature atmosphere under reduced pressure and thereby allows the removal of the reaction product. Although the effect mentioned above is higher as the heating temperature of each of the plates is higher, consideration should be given to the heat resistant temperature (which is mostly about 200 °C in current situations) of a peripheral part such as an O-ring in heating each of the plates. By using a part having a high heat resistant temperature as a peripheral part such as an O-ring, however, it is possible to heat each of the plates to about 500 °C.

In the second embodiment, the plasma need not be used in the cleaning step. However, it is also possible to apply an RF voltage between the lower and upper electrodes **102** and **103**, while introducing a cleaning gas into the reaction chamber **101** from the gas inlet port **106** through the blocker plate **104** and the face plate **105**, and perform cleaning using a plasma resulting from the application of the RF voltage simultaneously with the cleaning using the foregoing heaters **121** and **122**. At this time, it is also possible to set the distance between the face plate **105** (the second gas dispersing portion) and the blocker plate **104** (the first gas dispersing portion) to a value which allows sufficient generation of a plasma with the application of an RF voltage and individually apply first and second RF voltages between the face plate **105** and the blocker plate **104** and between the face plate **105** and the lower electrode **102**, in the same manner as in the first embodiment. In the arrangement, respective plasmas each composed of the cleaning gas are generated in the respective regions lying between the face plate **105** and the lower electrode **102** and between the face plate **105** and the blocker plate **104** and the reaction product that has adhered to the inner walls of the reaction chamber **101**, the individual plates, and the gas holes therein can be decomposed and removed by using the plasmas.

Although the second embodiment has provided the first heaters **121** on the blocker plate **104** and the second heaters **122** on the face plate **105**, it is also possible to provide a heater on either one of the plates instead. The positions of the plates to which the heaters are attached are not particularly limited. In the present embodiment, either one of the blocker plate **104** and the face plate **105** may not be provided.

Although the second embodiment has described primarily the case where the chemical vapor deposition system is used, the same effects are achievable even when another substrate processing apparatus, e.g., a plasma etching apparatus (particularly the electrode structure and the cleaning of the apparatus) using a depositive gas is used instead.

### EMBODIMENT 3

Referring to the drawings, a substrate processing apparatus according to a third embodiment of the present invention and a cleaning method therefor will be described herein below.

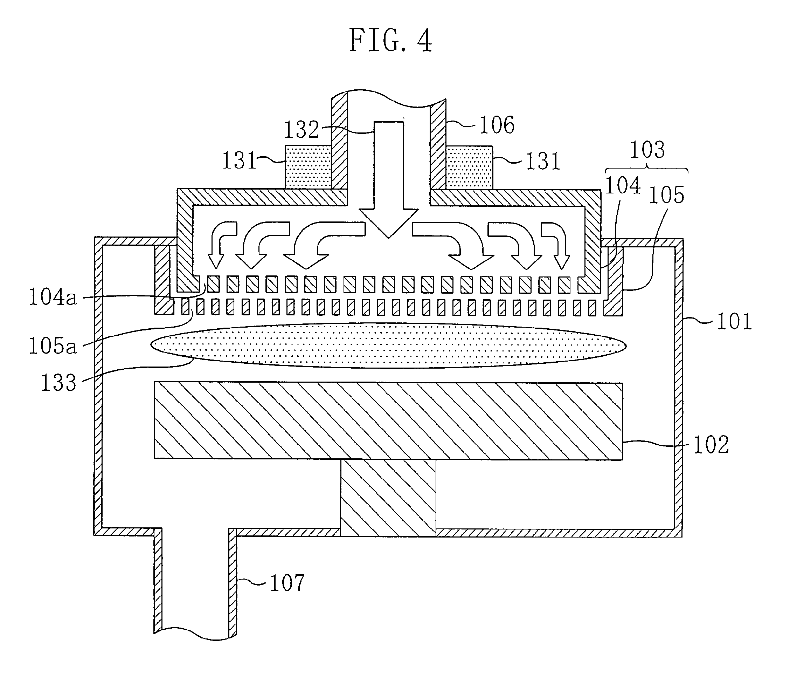

FIG **4** shows a schematic cross-sectional structure of the substrate processing apparatus (specifically a chemical vapor deposition system) according to the third embodiment. The description of the members shown in FIG **4** which are the same as those shown in FIGS. **1** and **2** will be omitted by retaining the same reference numerals as used in the first embodiment.

As shown in FIG **4**, the upper electrode **103** for generating a plasma is composed of the blocker plate **104** and the face plate 105 in the substrate processing apparatus according to the present embodiment in the same manner as in the first embodiment. However, the present embodiment is characterized in that an ultrasonic vibration source **131** capable of transmitting an ultrasonic vibration to the blocker plate **104**, i.e., the upper electrode **103** has been attached in fixed relation to the ceiling portion of the blocker plate **104**. Although the present embodiment has attached the side portions of the face plate **105** to the ceiling portion of the reaction chamber **101** without intervention of the mechanism **105b** according to the first embodiment, it will easily be appreciated that the mechanism **105b** may also be provided.

In the film deposition step in the chemical vapor deposition system according to the present embodiment, the target substrate (wafer) **100** is placed on the lower electrode **102** and then a process gas is introduced into the reaction chamber **101** from the gas inlet port **106** through the gas holes in each of the blocker plate **104** and the face plate **105**, in the same manner as in the first embodiment. At this stage, a plasma composed of the process gas is generated in the region lying between the lower and upper electrodes **102** and **103** by applying an RF voltage between the lower and upper electrodes **102** and **103** and film deposition on the target substrate **100** is performed by exposing the target substrate **100** to the plasma. Alternatively, thermal CVD is performed instead of performing plasma CVD by heating the lower electrode **102** to about 400 °C using the heaters (not shown) so that film deposition on the target substrate **100** is performed.

In the cleaning step using the chemical vapor deposition system according to the present embodiment, the target substrate **100** is retrieved from the reaction chamber **101** after the completion of the film deposition step described above. Then, the blocker plate **104** and the face plate **105** are vibrated by using the ultrasonic vibration source **131**. The vibration allows efficient mechanical removal of the reaction product that has adhered to the gas holes **104a** in the blocker plate **104** and to the gas holes **105a** in the face plate **105**. At this time, it is also possible to introduce a cleaning gas **132** into the reaction chamber **101** from the gas inlet port **106** through the blocker plate **104** and the face plate **105**, while applying an RF voltage between the lower and upper electrodes **102** and **103**, and thereby perform cleaning using the plasma **133** resulting from the application of the RF voltage.

In the third embodiment, the plasma need not be used in the cleaning step. It is also possible to set the distance between the face plate **105** (the second gas dispersing portion) and the blocker plate **104** (the first gas dispersing portion) to a value which allows sufficient generation of a plasma with the application of an RF voltage and individually apply first and second RF voltages between the face plate **105** and the blocker plate **104** and between the face plate **105** and the lower electrode **102**, in the same manner as in the first embodiment. In the arrangement, respective plasmas each composed of the cleaning gas are generated in the respective regions lying between the face plate **105** and the lower electrode **102** and between the face plate **105** and the blocker plate **104** and the reaction product that has adhered to the inner walls of the reaction chamber **101**, the individual plates, and the gas holes therein can be decomposed and removed by using the plasmas.

In the third embodiment, the cleaning performed by using the heaters in the second embodiment may also be performed in combination with the cleaning performed by using the ultrasonic vibration source **131**.

The position at which the ultrasonic vibration source **131** is disposed is not particularly limited provided that an ultrasonic vibration can be transmitted to the blocker plate **104** and to the face plate **105**. In other words, a single or a plurality of ultrasonic vibration sources may be provided at arbitrary positions on the upper electrode **103** composed of the blocker plate **104** and the face plate **105**. In the present embodiment, either one of the blocker plate **104** and the face plate **105** may not be provided.

Although the third embodiment has described primarily the case where the chemical vapor deposition system is used, the same effects are achievable even when another substrate processing apparatus, e.g., a plasma etching apparatus (particularly the electrode structure and the cleaning of the apparatus) using a depositive gas is used instead.

### EMBODIMENT 4

Referring to the drawings, a substrate processing apparatus according to a fourth embodiment of the present invention and a cleaning method therefor will be described herein below.

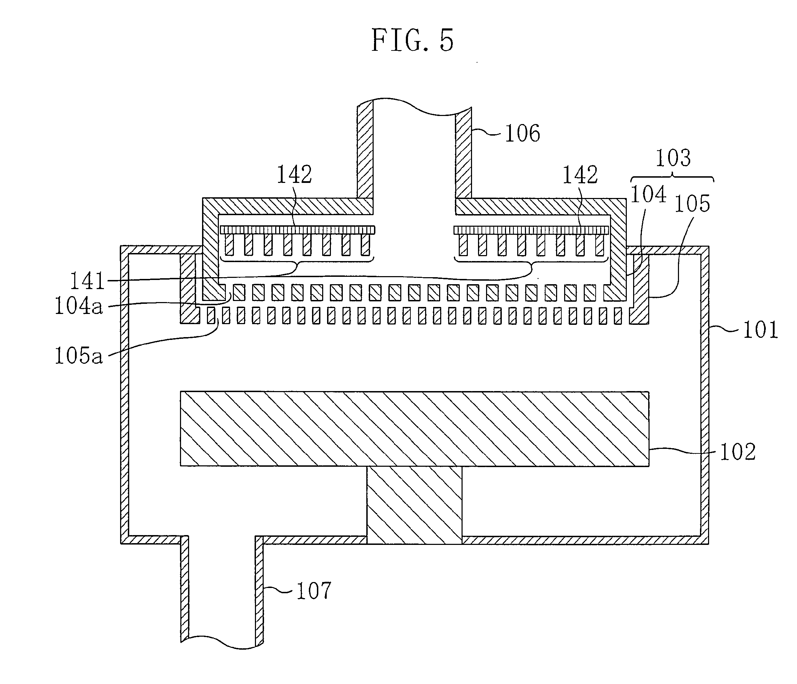

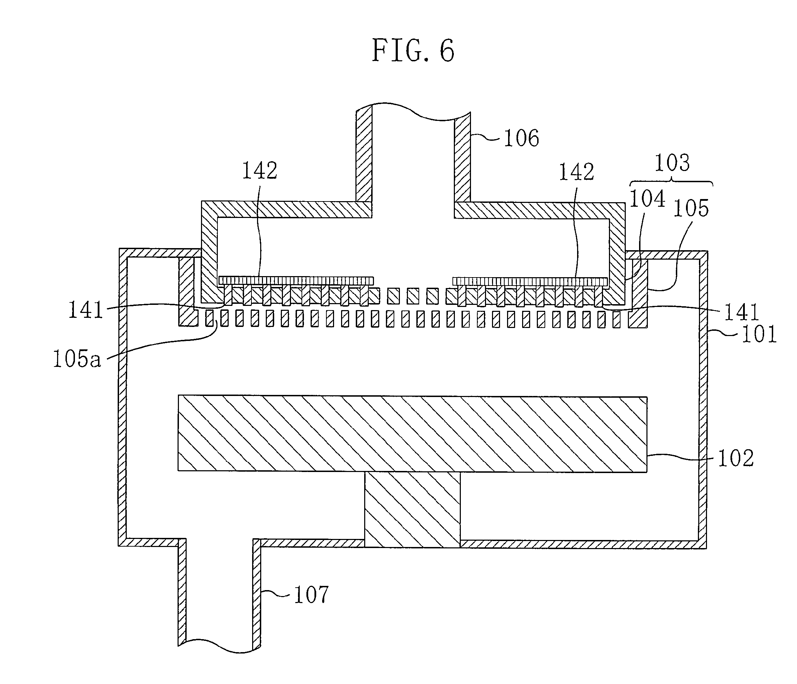

FIGS. **5** and **6** show schematic cross-sectional structures of the substrate processing apparatus (specifically a chemical vapor deposition system) according to the fourth embodiment. The description of the members shown in FIGS. **5** and **6** which are the same as those shown in FIGS. **1** and **2** will be omitted by retaining the same reference numerals as used in the first embodiment.

As shown in FIG **5**, the upper electrode **103** for generating a plasma is composed of the blocker plate **104** and the face plate **105** in the substrate processing apparatus according to the present embodiment in the same manner as in the first embodiment. However, the present embodiment is characterized in that a plurality of pins **141** opposing at least those of the plurality of gas holes **104a** in the blocker plate **104** which are provided in the peripheral portion thereof (i.e., the gas holes **104a** to which a reaction product generated in the film deposition step described later is likely to adhere) are provided between the gas inlet port **106** and the blocker plate **104** (i.e., in the space enclosed by the blocker plate **104**). In short, the pins **141** are opposed to the corresponding gas holes **104a** in a one-to-one correspondence. Each of the pins **141** is coupled to a mechanism **142** capable of moving the pins **141** in upward and downward directions (vertical directions). In other words, the pins **141** can be fitted in the specified gas holes **104a** in the blocker plate **104** in a one-to-one correspondence by using the mechanism **142**, as shown in FIG **6**.

Although the present embodiment has attached the side portions of the face plate **105** to the ceiling portion of the reaction chamber **101** without intervention of the mechanism **105b** according to the first embodiment, it will easily be appreciated that the mechanism **105b** may also be provided.

In the film deposition step in the chemical vapor deposition system according to the present embodiment, the target substrate (wafer) **100** is placed on the lower electrode **102** in the state in which the pins **141** have not been fitted in the gas holes **104a** in the blocker plate **104** (see FIG 5) and then a process gas is introduced into the reaction chamber **101** from the gas inlet port **106** through the gas holes in each of the blocker plate **104** and the face plate **105**, in the same manner as in the first embodiment. At this stage, a plasma composed of the process gas is generated in the region lying between the lower and upper electrodes **102** and **103** by applying an RF voltage between the lower and upper electrodes **102** and **103** and film deposition on the target substrate **100** is performed by exposing the target substrate **100** to the plasma. Alternatively, thermal CVD is performed instead of performing plasma CVD by heating the lower electrode **102** to about 400 °C using the heaters (not shown) so that film deposition on the target substrate is performed.

In the cleaning step using the chemical vapor deposition system according to the present embodiment, the target substrate **100** is retrieved from the reaction chamber **101** after the completion of the film deposition step described above and then a cleaning gas is introduced into the reaction chamber **101** from the gas inlet port **106** through the blocker plate **104** and the face plate **105**, while an RF voltage is applied between the lower and upper electrodes **102** and **103** to generate a plasma so that the reaction chamber **101** is internally cleaned by using the plasma, in the same manner as in the first embodiment. The present embodiment is characterized in that, before or after the cleaning step or during the cleaning step, the pins **141** are simultaneously lowered in level by using the mechanism **142** to be simultaneously fitted into the specified gas holes **104a** in the blocker plate **104**, as shown in FIG **6**, so that the reaction product that has adhered to the inner wall surfaces of the gas holes **104a** are thereby pushed out to be removed. By thus performing the cleaning using the pins **141** in combination with the cleaning using the plasma, efficient cleaning can be performed.

In the fourth embodiment, the plasma need not be used in the cleaning step. In other words, only cleaning using the pins **141** may be performed in the cleaning step. In the case of performing cleaning using a plasma, it is also possible to set the distance between the face plate **105** (the second gas dispersing portion) and the blocker plate **104** (the first gas dispersing portion) to a value which allows sufficient generation of a plasma with the application of an RF voltage and individually apply first and second RF voltages between the face plate **105** and the blocker plate **104** and between the face plate **105** and the lower electrode **102**, in the same manner as in the first embodiment. In the arrangement, respective plasmas each composed of the cleaning gas are generated in the region lying between the face plate **105** and the lower electrode **102** and between the face plate **105** and the blocker plate **104** and the reaction product that has adhered to the inner walls of the reaction chamber **101**, the individual plates, and the gas holes therein can be decomposed and removed by using the plasmas.

In the fourth embodiment, the cleaning using the heaters according to the second embodiment and (or) the cleaning using the ultrasonic vibration source according to the third embodiment may also be performed in combination with the cleaning using the pins **141.**

Although the fourth embodiment has provided the pins **141** corresponding in number to the specified ones of the gas holes **104a** in the blocker plate **104**, it is also possible to provide the pins **141** corresponding in number to all the gas holes **104a** in the blocker plate **104** instead. In the present embodiment, the face plate **105** need not be provided.

Although the fourth embodiment has described primarily the case where the chemical vapor deposition system is used, the same effects are achievable even when another substrate processing apparatus, e.g., a plasma etching apparatus (particularly the electrode structure and the cleaning of the apparatus) using a depositive gas is used instead.

### EMBODIMENT 5

Referring to the drawings, a substrate processing apparatus according to a fifth embodiment of the present invention and a cleaning method therefor will be described herein below.

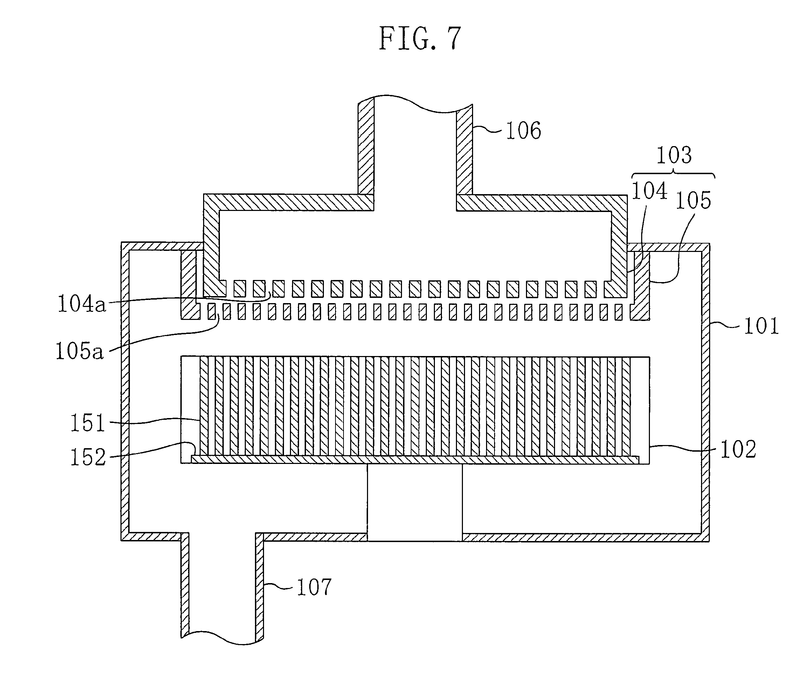

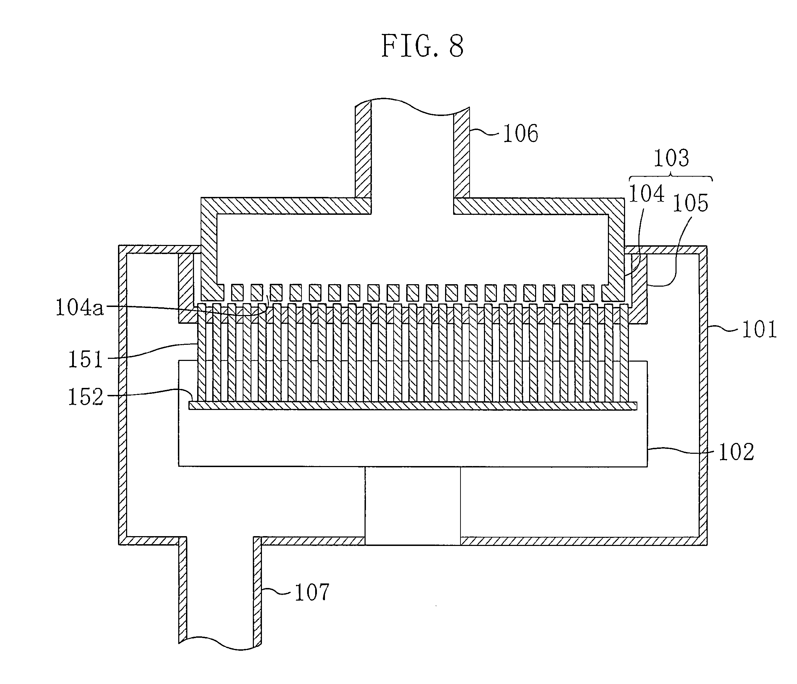

FIGS. **7** and **8** show schematic cross-sectional structures of the substrate processing apparatus (specifically a chemical vapor deposition system) according to the fifth embodiment. The description of the members shown in FIGS. **7** and **8** which are the same as those shown in FIGS. **1** and **2** will be omitted by retaining the same reference numerals as used in the first embodiment.

As shown in FIGS. **7** and **8**, the upper electrode **103** for generating a plasma is composed of the blocker plate **104** and the face plate **105** in the substrate processing apparatus according to the present embodiment in the same manner as in the first embodiment. However, the present embodiment is characterized in that a plurality of pins **151** that can be fitted into the gas holes **105a** in the face plate **105** in a one-to-one correspondence are provided under the face plate **105**. Each of the pins **151** is coupled to a mechanism **152** capable of moving the pins **151** in upward and downward directions (vertical directions).

Although the present embodiment has attached the side portions of the face plate **105** to the ceiling portion of the reaction chamber **101** without intervention of the mechanism **105b** according to the first embodiment, it will easily be appreciated that the mechanism **105b** may also be provided.

In the film deposition step in the chemical vapor deposition system according to the present embodiment, each of the pins **151** is contained together with the mechanism **152** within the lower electrode **102** which also serves as the substrate support, as shown in FIG **7**. The pins **151** are disposed at positions opposing the gas holes **105a** in the face plate **105** in a one-to-one correspondence. In this state, the target substrate (wafer) **100** is placed on the lower electrode **102** and then a process gas is introduced into the reaction chamber **101** from the gas inlet port **106** through the gas holes in each of the blocker plate **104** and the face plate **105**, in the same manner as in the first embodiment. At this stage, a plasma composed of the process gas is generated in the region lying between the lower and upper electrodes **102** and **103** by applying an RF voltage between the lower and upper electrodes **102** and **103** and film deposition on the target substrate **100** is performed by exposing the target substrate **100** to the plasma. Alternatively, thermal CVD is performed instead of performing plasma CVD by heating the lower electrode **102** to about 400 °C using the heaters (not shown) so that film deposition on the target substrate **100** is performed.

In the cleaning step using the chemical vapor deposition system according to the present embodiment, the target substrate **100** is retrieved from the reaction chamber **101** after the foregoing film deposition step is completed and then a cleaning gas is introduced into the reaction chamber **101** from the gas inlet port **106** through the blocker plate **104** and the face plate **105**, while an RF voltage is applied between the lower and upper electrodes **102** and **103** to generate a plasma so that the reaction chamber **101** is internally cleaned by using the plasma, in the same manner as in the first embodiment. The present embodiment is characterized in that, before or after the cleaning step or during the cleaning step, the pins **151** are raised in level by using the mechanism **152**, i.e., protruded from the lower electrode **102** as the substrate support to be simultaneously fitted into the individual gas holes **105a** in the face plate **105**, as shown in FIG **8**, so that the reaction product that has adhered to the inner wall surfaces of the gas holes **105a** are thereby pushed out to be removed. By thus performing the cleaning using the pins **151** in combination with the cleaning using the plasma, efficient cleaning can be performed.

In the fifth embodiment, the plasma need not be used in the cleaning step. In other words, only cleaning using the pins **151** may be performed in the cleaning step. In the case of performing cleaning using a plasma, it is also possible to set the distance between the face plate **105** (the second gas dispersing portion) and the blocker plate **104** (the first gas dispersing portion) to a value which allows sufficient generation of a plasma with the application of an RF voltage and individually apply first and second RF voltages between the face plate **105** and the blocker plate **104** and between the face plate **105** and the lower electrode **102**, in the same manner as in the first embodiment. In the arrangement, respective plasmas each composed of the cleaning gas are generated in the region lying between the face plate **105** and the lower electrode **102** and between the face plate **105** and the blocker plate **104** and the reaction product that has adhered to the inner walls of the reaction chamber **101**, the individual plates, and the gas holes therein can be decomposed and removed by using the plasmas.

In the fifth embodiment, the cleaning using the heaters according to the second embodiment, the cleaning using the ultrasonic vibration source according to the third embodiment, and (or) the cleaning using the pins with respect to the gas holes **104a** in the blocker plate **104** according to the fourth embodiment may also be performed in combination with the cleaning using the pins **151** with respect to the gas holes **105a** in the face plate **105**.

Although the fifth embodiment has provided the pins **151** corresponding in number to all the gas holes **105a** in the face plate **105**, it is also possible to provide the pins **151** corresponding in number to the specified ones of the gas holes **105a** in the face plate **105** (e.g., the gas holes **105a** in the vicinity of the periphery to which a reaction product generated in the film deposition step is likely to adhere). In the present embodiment, the blocker plate **104** need not be provided.

Although each of the pins **151** is contained within the lower electrode **102** during the film deposition step in the fifth embodiment, each of the pins **151** may also be retracted in a place other than the inside of the lower electrode **102** which does not interrupt the film deposition step.

Although the fifth embodiment has described primarily the case where the chemical vapor deposition system is used, the same effects are achievable even when another substrate processing apparatus, e.g., a plasma etching apparatus (particularly the electrode structure and the cleaning of the apparatus) using a depositive gas is used instead.

### EMBODIMENT 6

Referring to the drawings, a substrate processing apparatus according to a sixth embodiment of the present invention will be described herein below.

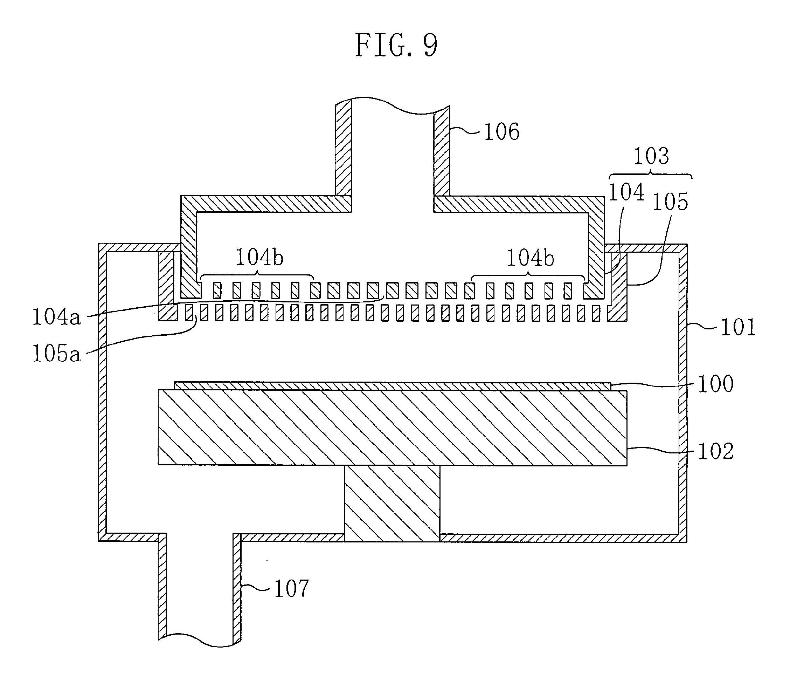

FIG **9** shows a schematic cross-sectional structure of the substrate processing apparatus (specifically a chemical vapor deposition system) according to the sixth embodiment. The description of the members shown in FIG **9** which are the same as those shown in FIGS. **1** and **2** will be omitted by retaining the same reference numerals as used in the first embodiment.

As shown in FIG **9**, the upper electrode **103** for generating a plasma is composed of the blocker plate **104** and the face plate **105** in the substrate processing apparatus according to the present embodiment in the same manner as in the first embodiment. However, the present embodiment is characterized in that, of the plurality of gas holes in the blocker plate **104** which disperse the process gas introduced from the gas inlet port **106** and thereby allow film deposition on the peripheral portion of the target substrate, gas holes **104b** arranged in the peripheral portion of the blocker plate **104** are larger in size than the gas holes **104a** arranged in the center portion thereof. The size of each of the gas holes **104a** and **104b** indicates a diameter when the plan configuration of each of the holes is, e.g., circular. Specifically, the size (diameter) of each of the gas holes **104a** in the center portion of the blocker plate **104** is 0.6 mm, while the size (diameter) of each of the gas holes **104b** in the peripheral portion thereof is 1.2 mm.

In the present embodiment, the plurality of gas holes **105a** provided in the face plate **105** have the same size over the entire surface of the plate. Although the present embodiment has attached the side portions of the face plate **105** to the ceiling portion of the reaction chamber **101** without intervention of the mechanism **105b** according to the first embodiment, it will easily be appreciated that the mechanism **105b** may also be provided.

As described above in "SUMMARY OF THE INVENTION", the reaction product is likely to adhere to the outlet and inlet of each of the gas holes in the blocker plate and in the face plate during film deposition in the conventional chemical vapor deposition system. It has actually been proved that the reaction product is likely to adhere particularly to the gas holes in the vicinity of the periphery of the blocker plate.

In view of the foregoing, the present embodiment has adjusted the size (e.g., diameter) of each of the gas holes **104b** in the peripheral portion of the blocker plate **104** to be larger than the size (e.g., diameter) of each of the gas holes **104a** in the center portion thereof and thereby reduce the time during which a gas for film deposition (process gas) dwells in the gas holes **104b** in the peripheral portion of the plate. This suppresses the adhesion of a deposit resulting from the reaction of the gas to the gas holes **104b** in the peripheral portion of the blocker plate **104** and thereby achieves a reduction in the degree of the degradation of film thickness uniformity across the surface of the target substrate (wafer) even when the film deposition step is repeatedly performed.

The sixth embodiment has adjusted the size of each of the gas holes **104b** arranged in the peripheral portion of the blocker plate **104** to be larger than the size of each of the gas holes **104a** in the center portion thereof. By contrast, the gas holes in the face plate are preferably formed to have the same diameter over the entire surface of the plate because the size (gas hole diameter) of each of the gas holes in the face plate is a factor which determines the final flow rate of the gas. Instead of or in addition to varying the gas hole diameter over the blocker plate **104**, however, it is also possible to adjust the size of each of the gas holes in the peripheral portion of the face plate **105** to be larger than the size of each of the gas holes in the center portion of the face plate **105** under given limited conditions. In the present embodiment, either of the blocker plate **104** and the face plate **105** (that one of the plates in which the gas holes in the peripheral portion and the gas holes in the center portion thereof do not have different sizes) may not be provided.

Although the chemical vapor deposition system has been described primarily in the sixth embodiment, the same effects are achievable even when another substrate processing apparatus, e.g., a plasma etching apparatus (particularly the electrode structure) using a depositive gas is used instead. It is also possible to apply the structure of the present embodiment in which the gas holes in the peripheral portion of the plate and the gas holes in the center portion thereof have different sizes to the substrate processing apparatus according to each of the first to fifth embodiments.

### EMBODIMENT 7

Referring to the drawings, a substrate processing apparatus according to a seventh embodiment of the present invention will be described herein below.

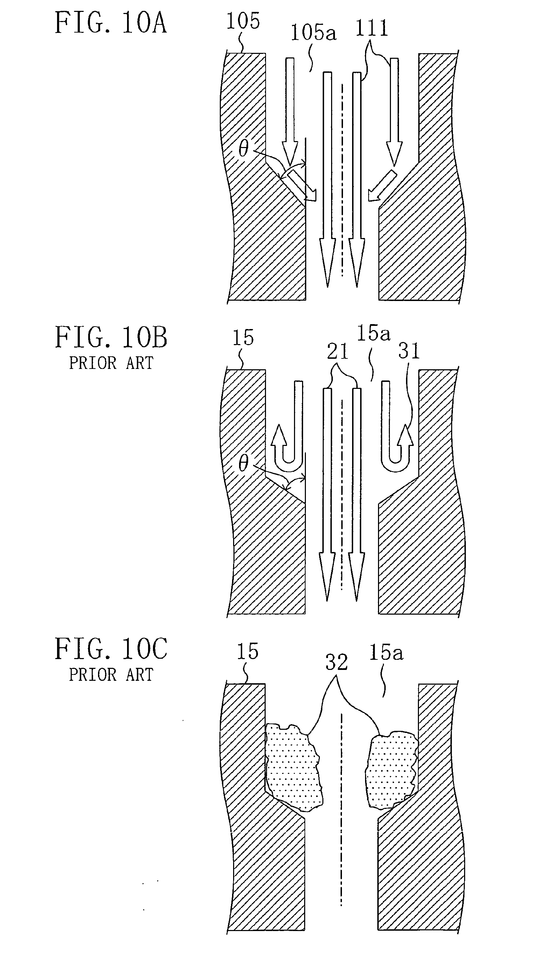

FIG **10A** is a view showing a cross-sectional structure of one of gas holes in the face plate of a substrate processing apparatus (specifically a chemical vapor deposition system) according to the seventh embodiment. The basic structure of the substrate processing apparatus according to the present embodiment is the same as that of the conventional apparatus shown in FIGS. **11A** and **11B** or that of each of the apparatus according to the first to sixth embodiments of the present invention shown in FIGS. **1** to **9.** Specifically, each of the gas holes (the gas holes in the face plate) according to the present embodiment has a cross-sectional structure which is different from that of each of the gas holes according to the conventional embodiment and the first to sixth embodiments of the present invention. A description will be given herein below to the configuration of each of the gas holes **105a** in the face plate **105** which characterizes the present embodiment on the assumption that the base structure of the substrate processing apparatus according to the present embodiment is the same as that of the substrate processing apparatus according to the sixth embodiment shown in FIG **9** (except for the structure which impart different sizes to the gas holes in the peripheral portion of the plate and to the gas holes in the center portion thereof). For a comparison with the structure of the gas hole **105a** according to the present embodiment, FIGS. **10B** and **10C** show cross-sectional structures of one of the gas holes **15a** in the face plate **15** of the conventional substrate processing apparatus.

In the conventional chemical vapor deposition system, there is a case where the gas hole **15a** is designed to have a size (e.g., diameter) which is reduced at a midpoint thereof for the stable flow rate of a gas (the reactive gas **21**), as shown in FIG **10B**. In this case, the tilt angle θ of an inclined surface (which is a part of the inner wall surface of the gas hole **15a**) resulting from the midpoint reduction in the size (e.g., diameter) of the gas hole **15a** relative to the flowing direction (direction along the dash-dot line in the drawing) of the gas **21** becomes 50° or more. The magnitude of the tilt angle results from the angle of the cutting edge of a drill for providing the gas hole **15a** in the face plate **15.**

The present inventors have proved that such a conventional chemical vapor deposition system encounters the following problem. That is, a turbulent **31** occurs in the gas **21** at the portion (constricted portion) of the gas hole **15a** in the face plate **15** which is reduced in size, as shown in FIG **10B**. The turbulent **31** causes a backward flow or stagnation in a part of the gas **21** so that the gas **21** is supplied also to the inclined surface of the gas hole **15a**. As a result, the reaction product **32** adheres to the inner wall surface of the gas hole **15a**, as shown in FIG **10C**.

By contrast, the present embodiment has set the tilt angle θ of the inclined surface (which is a part of the inner wall surface of the gas hole **105a**) resulting from the midpoint size reduction of the gas hole **105a** relative to the flowing direction (direction along the dash-dot line in the drawing) of the gas **111** to a degree not more than 45° as shown in FIG **10A**, though the present embodiment is the same as the conventional embodiment in that the portion of each of the gas holes **105a** in the face plate **105** which is closer to the inlet for the gas (process gas) **111** is larger in size than the portion of the gas hole **105a** which is closer to the outlet for the gas **111**. This prevents the occurrence of the turbulent in the gas hole **105a** and reduces an amount of the reaction product resulting from the process gas **111** for film deposition and adhered to the inner wall surface of the gas hole **105a**. Even when the film deposition step is repeated a large number of times, the situation can therefore be circumvented in which the substantial size of the gas hole **105a** is reduced as a result of the adhesion of the reaction product so that the amount of the gas **111** passing through the gas hole **105a** is prevented from becoming unstable. As a result, the thickness of a film formed on the target substrate surface (wafer surface) can be prevented from becoming gradually non-uniform even when the film deposition step is repeatedly performed.

In the seventh embodiment, the tilt angle of the inclined surface of the inner wall surface of the gas hole **105a** is preferably at least 10° or more for the stable flow rate of the gas.

The seventh embodiment has also set the tilt angle of the inclined surface of the inner wall surface of each of the gas holes **105a** in the face plate **105** to a specified degree or less. However, it is also possible to set the tilt angle of the inclined surface of the inner wall surface of each of the gas holes **104a** in the blocker plate **104** to a specified degree or less instead of or in addition to adjusting the tilt angle of the inclined surface of the inner wall surface of the gas hole **105a** in the face plate **105**. In the present embodiment, either one (that one of the plates in which the tilt angle of the inclined surface is not set to a specified degree or less) of the blocker plate **104** and the face plate **105** may not be provided.

Although the seventh embodiment has described primarily the case where the chemical vapor growth apparatus is used instead, the same effects are achievable even when another substrate processing apparatus, e.g., a plasma etching apparatus (particularly the electrode structure) using a depositive gas is used. It is also possible to apply the structure of the present embodiment in which the tilt angle of the inclined surface of the inner wall surface of each of the gas holes in the plate to a specified degree or less to each of the substrate processing apparatus according to the first to sixth embodiments.

## Claims

1. A substrate processing apparatus comprising:
a pressure-reducible reaction chamber;
a substrate support provided in the reaction chamber;
a gas inlet port provided in a wall portion of the reaction chamber to introduce a gas into the reaction chamber;
a first plate provided between the substrate support and the gas inlet port in the reaction chamber and having a plurality of first holes for dispersing the gas introduced from the gas inlet port into the reaction chamber; and
a second plate provided between the substrate support and the first plate in the reaction chamber in opposing relation to the first plate and having a plurality of second holes for further dispersing the gas dispersed by the first plate, wherein
the first and second plates can be moved relatively to each other such that a spacing between the first and second plates is variable.

2. The substrate processing apparatus of claim 1, wherein a first RF voltage can be applied between the first and second plates and a second RF voltage can be applied between the second plate and the substrate support.

3. A substrate processing apparatus comprising:
a pressure-reducible reaction chamber;
a substrate support provided in the reaction chamber;
a gas inlet port provided in a wall portion of the reaction chamber to introduce a gas into the reaction chamber;
a plate provided between the substrate support and the gas inlet port in the reaction chamber and having a plurality of holes for dispersing the gas introduced from the gas inlet port into the reaction chamber; and
a heater provided on the plate to heat the plate.

4. The substrate processing apparatus of claim 3, wherein the plate is composed of:
a first plate having a plurality of first holes for dispersing the gas introduced from the gas inlet port into the reaction chamber; and
a second plate provided between the substrate support and the first plate in opposing relation to the first plate and having a plurality of second holes for further dispersing the gas that has been dispersed by the first plate.

5. A substrate processing apparatus comprising:
a pressure-reducible reaction chamber;
a substrate support provided in the reaction chamber;
a gas inlet port provided in a wall portion of the reaction chamber to introduce a gas into the reaction chamber;
a plate provided between the substrate support and the gas inlet port in the reaction chamber and having a plurality of holes for dispersing the gas introduced from the gas inlet port into the reaction chamber; and
a vibration source provided on the plate to apply an ultrasonic vibration to the plate.

6. The substrate processing apparatus of claim 5, wherein the plate is composed of:
a first plate having a plurality of first holes for dispersing the gas introduced from the gas inlet port into the reaction chamber; and
a second plate provided between the substrate support and the first plate in opposing relation to the first plate and having a plurality of second holes for further dispersing the gas that has been dispersed by the first plate.

7. A substrate processing apparatus comprising:
a pressure-reducible reaction chamber;
a substrate support provided in the reaction chamber;
a gas inlet port provided in a wall portion of the reaction chamber to introduce a gas into the reaction chamber;
a plate provided between the substrate support and the gas inlet port in the reaction chamber and having a plurality of holes for dispersing the gas introduced from the gas inlet port into the reaction chamber; and
a plurality of pins provided in the reaction chamber to oppose the plurality of holes in the plate in a one-to-one correspondence, wherein
the plurality of pins are movable to be fitted into the plurality of holes in a one-to-one correspondence.

8. The substrate processing apparatus of claim 7, wherein
the plate is composed of:
a first plate having a plurality of first holes for dispersing the gas introduced from the gas inlet port into the reaction chamber; and
a second plate provided between the substrate support and the first plate in opposing relation to the first plate and having a plurality of second holes for further dispersing the gas that has been dispersed by the first plate and
the plurality of the pins are provided movable between the gas inlet port and the first plate in opposing relation to the plurality of first holes in such a manner as to be fitted into the plurality of first holes in a one-to-one correspondence.

9. The substrate processing apparatus of claim 7, wherein
the plate is composed of:
a first plate having a plurality of first holes for dispersing the gas introduced from the gas inlet port into the reaction chamber; and
a second plate provided between the substrate support and the first plate in opposing relation to the first plate and having a plurality of second holes for further dispersing the gas that has been dispersed by the first plate and
the plurality of pins are containable in the substrate support and protruding movably from the substrate support to be fitted into the plurality of second holes in a one-to-one correspondence.

10. A substrate processing apparatus comprising:
a pressure-reducible reaction chamber;
a substrate support provided in the reaction chamber;
a gas inlet port provided in a wall portion of the reaction chamber to introduce a gas into the reaction chamber; and
a plate provided between the substrate support and the gas inlet port in the reaction chamber and having a plurality of holes for dispersing the gas introduced from the gas inlet port into the reaction chamber, wherein
that one of the plurality of holes which is located in a peripheral portion of the plate has a size larger than a size of that one of the plurality of holes located in a center portion of the plate.

11. A substrate processing apparatus comprising:
a pressure-reducible reaction chamber;
a substrate support provided in the reaction chamber;
a gas inlet port provided in a wall portion of the reaction chamber to introduce a gas into the reaction chamber; and
a plate provided between the substrate support and the gas inlet port in the reaction chamber and having a plurality of holes for dispersing the gas introduced from the gas inlet port into the reaction chamber, wherein
each of the plurality of holes is larger in size at a portion thereof closer to an inlet for the gas than at a portion thereof closer to an outlet for the gas and
a tilt angle of at least one portion of an inner wall surface of each of the plurality of holes relative to a flowing direction of the gas is not more than 45°.

12. A cleaning method for a substrate processing apparatus is a method for cleaning the substrate apparatus as recited in claim 2, the method comprising the steps of:
moving the first and second plates relatively to each other to set a spacing between the first and second plates to a value which allows generation of a plasma using the first RF voltage;
supplying a cleaning gas into the reaction chamber from the gas inlet port through the plurality of first holes in the first plate and the plurality of second holes in the second plate; and
applying at least one of the first and second RF voltages to generate a plasma composed of the cleaning gas in at least one of a space between the first and second plates and a space between the second plate and the substrate support and thereby remove a reaction product that has resulted from a process using the substrate processing apparatus and adhered to the first and second plates.

13. A cleaning method for a substrate processing apparatus is a method for cleaning the substrate apparatus as recited in claim 3, the method comprising the step of:
heating the plate to a temperature not less than 150 °C by using the heater and thereby removing a reaction product that has resulted from a process using the substrate processing apparatus and adhered to the plate.

14. A cleaning method for a substrate processing apparatus is a method for cleaning the substrate apparatus as recited in claim 5, the method comprising the step of:
applying an ultrasonic vibration to the plate by using the vibration source and thereby removing a reaction product that has resulted from a process using the substrate processing apparatus and adhered to the plate.
